(19) Europäisches Patentamt
European Patent Office
Office européen des brevets

(11) EP 3 115 197 A1

(12) **EUROPEAN PATENT APPLICATION**
published in accordance with Art. 153(4) EPC

(43) Date of publication:
**11.01.2017 Bulletin 2017/02**

(21) Application number: **15758675.1**

(22) Date of filing: **02.03.2015**

(51) Int Cl.:
***B32B 9/00*** *(2006.01)* ***C23C 16/40*** *(2006.01)*
***C23C 16/44*** *(2006.01)*

(86) International application number:
**PCT/JP2015/056105**

(87) International publication number:
**WO 2015/133441 (11.09.2015 Gazette 2015/36)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **04.03.2014 JP 2014041676**
**19.03.2014 JP 2014056600**

(71) Applicant: **Toyo Seikan Group Holdings, Ltd.**
**Shinagawa-ku**
**Tokyo 141-8627 (JP)**

(72) Inventors:
- **NANGOU, Shunya**
  **Yokohama-shi**
  **Kanagawa 240-0062 (JP)**
- **OBU, Yusuke**
  **Tokyo 141-8627 (JP)**
- **OKUYAMA, Shinpei**
  **Yokohama-shi**
  **Kanagawa 240-0062 (JP)**
- **KAWAHARA, Naru**
  **Yokohama-shi**
  **Kanagawa 240-0062 (JP)**

(74) Representative: **Raynor, Stuart Andrew**
**J A Kemp**
**14 South Square**
**Gray's Inn**
**London WC1R 5JJ (GB)**

(54) **GAS BARRIER LAMINATE**

(57) A gas barrier laminate 10 having a very thin metal oxide film (ALD film) 5 formed on an inorganic oxide layer 3 by an atomic layer deposition method, the inorganic oxide layer 3 including a metal oxide or a metal oxynitride that contains at least either Si or Al, and a ratio (d1/d2) of a thickness dl of the inorganic oxide layer 3 and a thickness d2 of the ALD film 5 being 3 to 50. The gas barrier laminate features not only a high degree of gas-barrier property but also excellent productivity.

Fig. 1

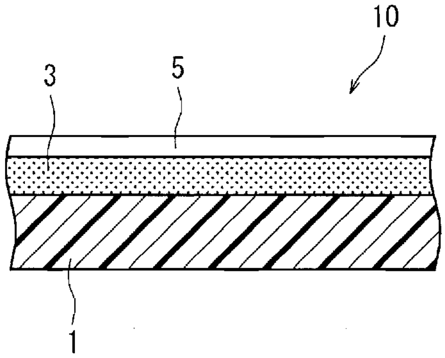


EP 3 115 197 A1

## Description

Technical Field:

This invention relates to a gas barrier laminate having a thin film that is formed on an inorganic layer by an atomic layer deposition method.

Background Art:

As means for improving properties and, specifically, gas barrier properties of various kinds of plastic base materials, there has been known an art of forming an inorganic barrier layer that comprises a silicon oxide and the like (patent document 1).

In a variety of electronic devices that are developed and put to practical use in recent years, such as organic electroluminescent devices (organic EL devices), solar cells, touch panels, and e-papers, it is a requirement to avoid the leakage of the electric charge. Therefore, a high water barrier property has been desired for the plastic base materials that form circuit boards or for the plastic base materials such as films for sealing the circuit boards. The above-mentioned inorganic barrier layer exhibits a higher degree of gas barrier property than that of organic films formed by using the so-called gas barrier resins accompanied, however, by structural defects such as pinholes and cracks due to the nature of the film, or M-OH bond (defective bond) that could become a gas passage in the M-O-M network that constitutes the film (M is a metal atom forming the inorganic barrier layer). Therefore, the inorganic barrier layer alone is not capable of satisfying a high degree of barrier property required in the field of organic EL devices, and it has been desired to further improve the gas barrier property.

The present applicant, for example, has previously proposed a gas barrier laminate comprising a water trapping layer using a cationic polymer as the matrix, that is formed on an inorganic barrier layer on a base film (Japanese Patent Application No. 2013-022253). However, the above gas barrier laminate still needs to suppress a drop in the barrier property caused by the structural defect inherent in the inorganic barrier layer and needs to attain more improved gas barrier property.

In recent years, further, studies have been forwarded concerning a film-forming method called atomic layer deposition (ALD) method, and there has also been proposed a gas barrier laminate having improved water barrier property by forming a film on an inorganic film by the above method (patent document 2).

According to the above technology, defects present in an inorganic film are repaired by forming a film on the inorganic film by the atomic layer deposition method so that gas barrier properties such as water barrier property and the like properties are greatly improved.

It has been known that the ALD film is a very dense film and can by itself exhibit a very high degree of barrier property. When it is desired to secure a water vapor permeability of, specifically, not more than $10^{-4}$ g/m$^2$/day, the film must have a thickness of, usually, not less than about 10 nm. Here, however, the film-forming method based on the atomic layer deposition (hereinafter often called ALD method) has a defect of low film-forming rate.

Namely, according to the ALD method, a gas of a metal compound such as A1 compound and water vapor are fed as reaction gases to form a monomolecular film of the metal oxide thereof. Next, the reaction gases are purged and, again, the reaction gases are fed. Thus the operation is repeated to laminate the metal oxide film one upon the other. Therefore, a considerable period of time is required to realize a desired high degree of barrier property accounting for a low productivity and preventing the method from being put into practical use.

Prior Art Documents:

Patent Documents:

Patent document 1: JP-A-2000-255579
Patent document 2: JP-A-2011-241421

Outline of the Invention:

Problems that the Invention is to Solve:

It is, therefore, an object of the present invention to provide a gas barrier laminate that has a film formed by the atomic layer deposition method on an inorganic film, featuring not only a high degree of gas barrier property but also

excellent productivity.

Another object of the present invention is to provide a gas barrier laminate which sustains, specifically, water barrier property of a high level over extended periods of time.

Means for Solving the Problems:

The present inventors have conducted experiments extensively about the gas barrier property of when a film is formed by the atomic layer deposition method on an inorganic film, have discovered the fact that if certain conditions are satisfied, the inorganic film exhibits greatly improved gas barrier property even if the film formed by the atomic layer deposition method has a very small thickness, and have thus completed the invention.

According to the present invention, there is provided a gas barrier laminate having a very thin metal oxide film formed on an inorganic oxide layer by an atomic layer deposition method, the inorganic oxide layer including a metal oxide or a metal oxynitride that contains at least either Si or Al, and a ratio (d1/d2) of a thickness d1 of the inorganic oxide layer and a thickness d2 of the very thin metal oxide film being 3 to 50.

In the gas barrier laminate of the present invention, it is desired that:

(1) The very thin metal oxide film has a thickness d2 in a range of 0.5 to 9 nm;
(2) The very thin metal oxide has a density of not less than 4.2 g/$cm^3$;
(3) The inorganic oxide layer is formed on a plastic base material;
(4) The inorganic oxide layer has an MOH/MO ratio (M is Si or Al) of not more than 0.1;
(5) The very thin metal oxide film contains Ti, Zr, Hf or Al; and
(6) The inorganic oxide layer includes an oxide that contains Si, and a cationic material is formed on the very thin metal oxide film.

Effects of the Invention:

The gas barrier laminate of the present invention has a stratified structure in which a film (ALD film) is formed by the atomic layer deposition method on an inorganic oxide layer that is formed on the surface of a base material such as plastic base material. Here, the invention has a striking feature in that the inorganic oxide layer comprises an oxide or an oxynitride of Si or Al and, further, that the ALD film formed thereon has a thickness which is as very small as not more than one-third of the thickness of the inorganic oxide layer. Namely, a ratio (d1/d2) of a thickness d1 of the inorganic oxide layer and a thickness d2 of the ALD film (very thin metal oxide film) is 3 to 50.

Thus, the ALD film is very thin and can be formed in a short period of time. For example, if the reaction with the inorganic oxide layer and the purging thereof are regarded to constitute a cycle and if the thickness of a monoatomic layer obtained by one cycle is 0.2 nm, then the number of the cycles needed for forming the film is not more than 45. Therefore, despite of being provided with the ALD film, the gas barrier laminate of the present invention can be produced highly efficiently.

Further, despite the ALD film formed on the inorganic oxide layer is very thin, the gas barrier laminate of the present invention has a very high degree of gas barrier property. For instance, as will also be learned from the Examples appearing later, the gas barrier film of the invention having the ALD film formed on the inorganic oxide layer ($SiO_x$ layer) according to the present invention, exhibits water barrier property (water vapor barrier property) that is improved by 3 folds or more and, specifically, by 40 folds or more as compared to that of the gas barrier film without having the ALD film. Namely, it is quite an astonishing fact that the ALD film brings about striking improvements in the gas barrier property despite its thickness is very small.

In the present invention, it has not been clarified yet why the gas barrier property is so strikingly improved. However, the present inventors are presuming that this is due to that defects such as pinholes in the inorganic oxide layer are repaired by the formation of the ALD film of a very small thickness.

That is, when the ALD layer is being formed, molecules of the oxide having a density higher than that of the inorganic oxide layer infiltrate selectively into the defects in the inorganic oxide and, besides, the starting gases called precursors, such as metal alkoxides and the like, react with the OH groups present in the defective portions in the inorganic oxide layer. Thus defects are presumably repaired and, therefore, the gas barrier property is strikingly improved.

The present invention exhibits remarkable effects particularly when a layer (water trapping layer) containing a cationic material is formed, via the above ALD film, on the inorganic oxide layer that contains Si.

Namely, the inorganic oxide layer containing Si has poor resistance against alkali. If the layer containing the cationic material is formed on the above layer, therefore, the layer comes in contact with the cations and defective bonds spread due to breakage in the Si-O-Si network. In the defective portions such as pinholes, in particular, cations infiltrate with the passage of time causing the defects to spread and, therefore, causing a decrease in the barrier property against oxygen and a decrease in the barrier property against water. In the present invention, on the other hand, defective bonds

in the inorganic oxide layer are repaired by the ALD film and, besides, the inorganic oxide layer is prevented from coming into direct contact with the cationic material. As a result, the inorganic oxide layer is effectively prevented from being deteriorated by the cationic material with the passage of time. Moreover, the layer containing the cationic material fully exhibits water trapping capability and a water barrier property of a high level yet suppressing a decrease in the barrier properties with the passage of time. Thus the gas barrier property of a high level is realized and lasts over extended periods of time.

The gas barrier laminate of the present invention exhibits very high gas barrier property such as water barrier property and can be, further, efficiently produced, and is useful as a base plate or a sealing layer for a variety of kinds of electronic devices, and is expected to be practically used, particularly, as panels for organic electroluminescent devices (organic EL devices).

Further, the ALD film that brings about improved gas barrier property and improved durability has a very small thickness, offering an advantage of providing such effects without the need of unnecessarily increasing the thickness of the laminate structure. Therefore, the ALD film of the present invention is industrially very useful.

Brief Description of the Drawings:

[Fig. 1] is a sectional view schematically showing the basic structure of layers of a gas barrier laminate of the present invention.

[Fig. 2] is a sectional view schematically showing a preferred structure of layers of a gas barrier laminate of the present invention.

[Fig. 3] is a sectional view schematically showing the structure of layers of a gas barrier laminate prepared in Example (Experiment 2).

Modes for Carrying Out the Invention:

<Basic structure of layers of the gas barrier laminate>

Referring to Fig. 1 which illustrates the basic structure of layers of a gas barrier laminate of the invention, the laminate generally designated at 10 includes a predetermined base material 1, an inorganic oxide layer 3 formed on the surface of the base material 1, and a very thin film 5 (hereinafter called ALD film) formed by an atomic layer deposition method.

Base material 1;

There is no specific limitation on the base material 1 that serves as an underlying layer for the inorganic oxide layer 3, and there may be used, for example, a metal or a glass. From the standpoint of the invention of realizing a high degree of gas barrier property, however, there is, usually, used a plastic base material. The plastic base material may be made of a known thermoplastic resin or a thermosetting resin.

Examples of the resin include, though not limited thereto only, olefin resins such as low-density polyethylene, high-density polyethylene, polypropylene, poly(1-butene), poly(4-methyl-1-pentene), random or block copolymers of $\alpha$ -olefins like ethylene, propylene, 1-butene and 4-methyl-1-pentene, and cyclic olefin copolymers; ethylene-vinyl resins such as ethylene-vinyl acetate copolymer, ethylene-vinyl alcohol copolymer and ethylene-vinyl chloride copolymer; styrene resins such as polystyrene, acrylonitrile-styrene copolymer, ABS, and $\alpha$ -methylstyrene-styrene copolymer; vinyl resins such as polyvinyl chloride, polyvinylidene chloride, vinyl chloride-vinylidene chloride copolymer, poly (methyl acrylate) and poly(methyl methacrylate); polyamides such as nylon 6, nylon 6-6, nylon 6-10, nylon 11 and nylon 12; polyester resins such as polyethylene terephthalate (PET), polybutylene terephthalate and polyethylene naphthalate (PEN); polycarbonate resins; polyphenylene oxide resins; polyimide resins; polyamideimide resins; polyetherimide resins; fluorine-contained resins; allyl resins; polyurethane resins; cellulose resins; polysulfone resins; polyethersulfone resins; ketone resins; amino resins; or biodegradable resins such as polylactic acid and the like, as well as blends thereof or those resins that are suitably modified by copolymerization, or those having a multilayer structure.

Specifically, for the use that requires transparency, polyester resins such as PET and PEN are preferred among the above resins and for the use that, further, requires heat resistance, polycarbonate and polyimide resin are preferred.

The above-mentioned resins may be blended with known blending agents for resins, such as antioxidant, lubricant, etc., as a matter of course.

There is no specific limitation on the form of the plastic base material if it is capable of exhibiting barrier property against water or oxygen to a sufficient degree, and the plastic base material may assume any suitable form depending

on the use. Most generally, however, the plastic base material assumes the form of a plate, a film or a sheet.

The thickness and the like (e.g., flexibility, softness, strength, etc.) thereof are set to lie in suitable ranges depending on the use.

The plastic base material, depending on its form or the kind of the plastic material, can be formed by a known forming means, such as injection or co-injection forming, extrusion or co-extrusion forming, film- or sheet-forming, compression forming, or cast polymerization.

Inorganic barrier layer 3;

The inorganic oxide layer 3 formed on the base material 1 is formed by the physical vapor deposition as represented by sputtering, vacuum evaporation or ion plating, or the chemical vapor deposition as represented by plasma CVD. Specifically preferably, the inorganic oxide layer 3 is formed of an oxide or an oxynitride of Si ($SiO_x$ or $SiO_xN_y$) or an oxide or an oxynitride of Al ($Al_2O_x$ or $Al_2O_xN_y$). The inorganic oxide layer 3 may, as a matter of course, be a mixture of an oxide or oxynitride of Si and an oxide or oxynitride of Al. Specifically, it is desired that the inorganic oxide layer 3 is formed of an oxide containing Si from the standpoint of a high degree of barrier property against the water vapor and easy formation of the film by vapor deposition.

In the invention, it is particularly desired that the inorganic oxide layer 3 is formed by the plasma CVD from the standpoint of maintaining a high degree of adhesiveness to the plastic base material, easily controlling the film properties by controlling the film-forming conditions, and uniformly forming the film even on rugged surfaces.

The film is formed by the plasma CVD, i.e., by arranging the plastic base material 1 on which the inorganic oxide layer is to be formed in a plasma-treating chamber that maintains a predetermined degree of vacuum and that is shielded with metal walls, feeding a gas (reaction gas) of a metal or a compound containing the metal for forming the film and an oxidizing gas (usually, oxygen or NOx gas) together with a carrier gas such as argon or helium through a gas-feed pipe into the plasma-treating chamber, causing a glow discharge to take place in this state by applying microwave electric field or high-frequency electric field and, therefore, causing a plasma to generate based on the electric energy thereof so that the decomposition product of the compound is deposited on the surface of the plastic base material 1.

If the microwave electric field is employed, the film is formed by irradiating the interior of the plasma-treating chamber with the microwaves by using a waveguide. If the high-frequency electric field is employed, the film is formed by placing the base material 1 between a pair of electrodes in the plasma-treating chamber and applying a high-frequency electric field to the electrodes.

As the reaction gas, it is desired to use a gas of an organoaluminum compound such as trialkylaluminum, or a gas of an organosilicon compound. Desirably, however, there is used the organosilicon compound since the organoaluminum is self-igniting and is difficult to handle.

As the organosilicon compound, there can be used organosilane compounds such as hexamethyldisilane, vinyltrimethylsilane, methylsilane, dimethylsilane, trimethylsilane, diethylsilane, propylsilane, phenylsilane, methyltriethoxysilane, vinytriethoxysilane, vinyltrimethoxysilane, tetramethoxysilane, tetraethoxysilane, phenyltrimethoxysilane, methyltrimethoxysilane and methyltriethoxysilane; and organosiloxane compounds such as octamethylcyclotetrasiloxane, 1,1,3,3-tetramethyldisiloxane and hexamethyldisiloxane. There can be, further, used aminosilane, silazane and the like in addition to the above compounds. In this case, there can be formed a film chiefly comprising an oxynitride of Si.

The above-mentioned organometal compounds can be used alone or in a combination of two or more kinds.

In the invention, the MOH/MO ratio (M = Si or Al) in the inorganic oxide layer 3 formed as described above is adjusted to be, desirably, not more than 0.1. Namely, the molar ratio represents the ratio of defective bonds in the inorganic oxide layer 3; i.e., the larger the molar ratio (MOH is more), the more the defective bonds and the smaller the molar ratio (MOH is less), the less the defective bonds. This is because in a portion where the defective bonds are present, the M-O-M network is broken and MOH is formed.

The value of the MOH/MO ratio can be adjusted by adjusting the film-forming atmosphere or the film-forming conditions. For instance, in case the film is to be formed by the CVD method, the degree of oxidation of the film is increased by increasing the output of the microwaves or the high-frequency wave for glow discharge such that the value of the MOH/MO ratio is adjusted to lie within the above-mentioned range to thereby decrease the pinholes.

The MOH/MO ratio should ideally be brought into zero. If the MOH/MO ratio is too small, however, the film assumes very decreased flexibility and becomes so brittle as to easily develop cracks. Therefore, the MOH/MO ratio should not be less than 0.001 and, particularly preferably, should not be less than 0.005.

That is, in the present invention, if the MOH/MO ratio of the inorganic oxide layer 3 is set to lie within the above-mentioned range to suppress the defective bonds to some extent, the ALD film 5 that will be described later exhibits its effect of improving the gas barrier property to its maximum degree.

Further, if the CVD method is employed in the present invention, the output for glow discharge is increased to increase the degree of oxidation of the film so that the value of the MOH/MO ratio lies within the above-mentioned range. In this case, however, the OH groups in the inorganic oxide produce decreased interaction (chemical bond or hydrogen

bond) with the base material, and adhesiveness is often spoiled relative to the plastic base material. To avoid the above inconvenience, it is recommended to, first, start forming the film based on the CVD method with a low output, increase the amount of the organic component in the film near the interface relative to the plastic base material 1 thereby to increase affinity to the base material in this portion and, therefore, to increase close adhesion to the plastic base material 1. Forming the film with a low output is followed by forming the film with a high output to decrease the defective bonds such that the MOH/MO ratio lies in the above-mentioned range.

The thickness d1 of the inorganic oxide layer 3 may differ depending on the use of the gas barrier laminate 10 or the level of gas barrier property that is required. Generally, however, the thickness d1 should be so selected as to maintain a water vapor permeability of not more than $10^{-2}$ g/m$^2$/day and, particularly, not more than $10^{-3}$/m$^2$/day; i.e., the thickness d1 may be 4 to 500 nm and, specifically, about 30 to about 400 nm.

ALD film 5;

The ALD film 5 on the inorganic oxide layer 3 is a very thin metal oxide film formed by the atomic layer deposition method (ALD method). It is desired that the ALD film 5 is made from a metal oxide and has a film density of not less than 4.2 g/cm$^3$ from such a standpoint that it inters in the defects such as pinholes in the inorganic oxide layer 3 to repair the defects.

Examples of the metal oxide include titanium dioxide, zirconium dioxide, hafnium dioxide, zinc oxide, gallium oxide, vanadium oxide, niobium pentoxide, tantalum pentoxide, tungsten trioxide and aluminum oxide, which may be used alone or in a combination of two or more kinds.

Specifically, as shown in Fig. 3 described later, when a layer containing a cationic material (water trapping layer 7) is formed on the ALD layer 5, it is desired to use, among the above metal oxides, the metal oxide that has particularly large resistance against the alkali from the standpoint of preventing corrosion of the inorganic oxide layer 3 by the cationic material.

For example, it can be said that the metal oxide has large resistance against the alkali if the weight loss of the ALD film 5 is not more than 0. 05%, specifically, not more than 0.03% after it is dipped in a 1N sodium hydroxide aqueous solution maintained at 30°C for one hour. Concretely, among the above metal oxides, the oxides of Ti, Zr, Hf or Al and, specifically, the oxides of Zr or Ti are preferred. Among them, the oxide of Zr is most desired from the standpoint of improving both reactivity and gas barrier property.

The ALD layer 5 is formed by using a gas of an alkoxide of the metal X as a starting material, and feeding the starting material gas (called precursor) onto the inorganic oxide layer 3. Then the MOH (M is Si or Al) present on the inorganic oxide layer 3 reacts with the precursor, and the metal in the starting material gas bonds to the surface of the inorganic oxide layer 3 to form M-O-X.

Next, an inert gas such as argon is used as a purge gas to purge the by-produced alcohol and the unreacted precursor.

Thereafter, the reaction gases ($O_3$, $H_2O$, etc.) are fed while effecting the purging. Thus an X-O-X network is formed on the surface of the inorganic oxide layer 3 to thereby form a very thin film of an oxide of the metal X.

A cycle consisting of the above-mentioned processes is repeated to form the ALD film 5 as desired. That is, in the second cycle, the precursor, the purge gas and the reaction gases are fed again.

Here, in forming the ALD film 5 as described above, an alkoxide or an amide compound of the metal X is used as the precursor. When a plastic base material having a small heat resistance is used, in particular, it is desired to use a tetra-tertiary-butyl alkoxide that has a high vapor pressure and can be formed into a film at a low temperature.

As described above, the ALD film 5 is formed on the inorganic oxide layer 3. Here, the very thin film 5 is formed with the MOH present on the inorganic oxide layer 3 as starting points, the MOH being present as bonding terminals on the surface of the inorganic oxide layer 3. Further, the MOH that is the bonding terminal is present in large amounts on the inner walls in the defects such as pinholes that are necessarily present on the inorganic oxide layer 3. The starting material gas of ALD and the reaction gases infiltrate deep into the defects and form a film particularly in the defects. That is, in the present invention, formation of the film starts from the interior of the defects where there are present OH groups at the bonding terminals in large amounts. Therefore, defects on the inorganic oxide layer 3 are electively repaired with the ALD film 5.

For instance, if the film density is not less than 4.2 g/cm$^3$, the gas barrier property of the inorganic oxide layer 3 can be greatly improved despite the ALD film 5 has a very small thickness.

In the present invention, a ratio (d1/d2) of the thickness d1 of the inorganic oxide layer 3 and the thickness d2 of the ALD film 5 is set to lie in a range of 3 to 50 and, specifically, 6 to 50, and the thickness d2 of the ALD film 5 is set to satisfy the above thickness ratio. That is, if the thickness d1 of the inorganic oxide layer 3 is large, then the thickness d2 of the ALD layer 5 is set to be large, and if the thickness d1 of the inorganic oxide layer 3 is small, then the thickness d2 of the ALD layer 5 is set to be small so as to satisfy the above-mentioned condition.

Namely, the larger the thickness d1 of the inorganic oxide layer 3, the higher the gas barrier property of the

layer 3 accompanied, however, by an increase in the development of defects or cracks that may greatly affect the gas barrier property. To avoid this, the thickness of the ALD layer 5 must be increased. If the thickness d1 of the inorganic oxide layer 3 is small, defects such as cracks develop less and, therefore, only the pinhole defects need be repaired. Therefore, the ALD film 5 needs have a decreased thickness d2 for repairing the pinhole defects.

In the present invention, further, from the standpoint of improving productivity, it is desired that the thickness d2 of the ALD film 5 is set to lie in a range of 0.5 to 9 nm and, based on this, the thickness d2 of the inorganic oxide layer 3 is set. That is, the ALD film 5 having the thickness d2 lying within the above range can be formed by repeating the cycle of the above-mentioned production processes not more than 45 times, and a high productivity can be maintained.

Other layers;

As described above, the gas barrier laminate 10 of the present invention has a basic structure in which the ALD film 5 is formed on the inorganic oxide layer 3. Here, so far as the gas barrier property such as water barrier property is not impaired and the productivity is not greatly impaired, either, it is allowed to provide suitable organic layers on the ALD film 5 to impart surface smoothness, printing adaptability, weather resistance and surface protection.

The organic layers can be formed by using any resins if they can maintain high degree of adhesiveness to the ALD film 5. For instance, there can be used polyolefin resin, polyester resin, cycloolef in resin, (meth) acrylic resin, urethane resin, epoxy resin and halogen resin.

After the above organic layers have been formed, it is also allowable to form thereon an oxygen barrier layer of an ethylene-vinyl alcohol copolymer or an aromatic polyamide or to form an oxygen-absorbing layer that contains iron or a transition metal such as cobalt to, further, improve barrier property against oxygen. Or, to further improve barrier property against water vapor, it is allowable to form a water vapor-absorbing layer of polyolefin or cycloolefin in which zeolite and the like is dispersed.

These layers can be easily formed by known means such as co-extrusion, coating or dry-lamination by using a suitable adhesive.

Properties of the gas barrier layer can be further improved by, further, depositing an inorganic oxide layer on the above organic layers. The inorganic oxide layer may be the same as the inorganic oxide layer 3 mentioned above.

<Preferred structure of the layers of the gas barrier laminate>

In the gas barrier laminate of the present invention, the organic layers suitably formed on the ALD film 5 are most desirably the layers containing a cationic material from the standpoint of attaining the effects of the invention to a maximum degree. Fig. 2 illustrates a structure of these layers.

Namely, in Fig. 2, a water trapping layer 7 is provided on the ALD film 5 of the gas barrier laminate 10, the water trapping layer 7 containing the cationic material.

Water trapping layer 7;

The water trapping layer 7 absorbs moisture due to the cationic material contained therein, i.e., compensates for water barrier property of the inorganic oxide layer 3 so as to attain higher water barrier property. As described earlier, if the water trapping layer 7 is provided directly on the inorganic oxide layer 3, then the inorganic oxide layer 3 is corroded by the cationic material. As a result, barrier property against oxygen and water decreases with the passage of time. According to the present invention, the ALD film 5 is provided between the water trapping layer 7 and the inorganic oxide layer 3 to effectively avoid the corrosion caused by the cationic material in the water trapping layer 7.

There is no particular limitation on the cationic material used for forming the water trapping layer 7 so far as it has moisture absorbing capability. The water trapping layer 7 can be formed by, for example, dispersing an alkali compound in a resin. Usually, to maintain a high degree of water barrier property, it is desired that the cationic material is formed as a continuous layer. For this purpose, a cationic polymer is most desirably used.

The cationic polymer is a polymer that has, in the molecules thereof, a cationic group that could become a positive charge in water, such as primary to tertiary amino groups, quaternary ammonium group, pyridyl group, imidazole group and quaternary pyridinium group. In the cationic polymer, the cationic group has a strong nucleophilic action, and water is trapped by the hydrogen bond. Therefore, the water trapping layer 7 can be formed as a moisture absorbing matrix.

The amount of the cationic groups in the cationic polymer is, usually, such that the coefficient of water absorption (JIS K-7209-1984) of the formed moisture absorbing matrix is not less than 20% and, specifically, 30% to 45% in an atmosphere of a humidity of 80%RH and at 30°C.

The cationic polymer is obtained by selecting at least one of the cationic monomers represented by amine monomers such as allylamine, ethyleneimine, vinylbenzyltrimethylamine, [4-(4-vinylphenyl)-methyl]-trimethylamine and vinylbenzyltriethylamine; nitrogen-containing heterocyclic monomers such as vinylpyridine and vinylimidazole; and salts

thereof, polymerizing or copolymerizing the thus selected cationic monomer with other copolymerizable monomer and, as required, followed by partial neutralization by the treatment with an acid.

As said other copolymerizable monomer, though not limited thereto only, there can be exemplified styrene, vinyltoluene, vinylxylene, α-methylstyrene, vinylnaphthalene, α -halogenated styrenes, acrylonitrile, acrolein, methyl vinyl ketone, vinylbiphenyl and the like.

Instead of using the cationic monomer, it is also allowable to use a monomer having a functional group that is capable of introducing a cationic functional group, such as styrene, bromobutylstyrene, vinyltoluene, chloromethylstyrene, vinylpyridine, vinylimidazole, α -methylstyrene or vinylnaphthalene and, after the polymerization, execute the treatment such as amination or alkylation (for forming quaternary ammonium salt) to obtain a cationic polymer.

Among the above cationic polymers, the present invention uses, particularly preferably, a polyallylamine from the standpoint of forming a film.

The polymerization for forming the cationic polymer is, usually, a radical polymerization by heating using a polymerization initiator.

There is no specific limitation on the polymerization initiator. Representative examples thereof are organic peroxides such as octanoyl peroxide, lauroyl peroxide, t-butylperoxy-2-ethylhexanoate, benzoyl peroxide, t-butyl peroxyisobutyrate, t-butyl peroxylaurate, t-hexyl peroxybenzoate, and di-t-butyl peroxide. Usually, the polymerization initiator is used in an amount of 0. 1 to 20 parts by weight and, specifically, about 0.5 to about 10 parts by weight per 100 parts by weight of the cationic monomer (or monomer capable of introducing cationic groups).

The cationic polymer is obtained through the polymerization conducted as described above. If there is used a monomer capable of introducing cationic functional groups, then there may be executed, after the polymerization, a treatment for introducing cationic groups, such as amination or alkylation.

In the invention, the water trapping layer 7 containing the cationic polymer is easily formed by applying, onto the ALD film 5, a coating solution that comprises an organic solvent in which the cationic polymer is dispersed or dissolved, followed by drying. If the layer is formed by using the cationic polymer, it is desired that a crosslinked structure has been introduced in the layer from the standpoint of maintaining the mechanical strength without lowering the moisture absorbing capability and, at the same time, improving the dimensional stability. That is, with the crosslinked structure having been introduced, in case the water trapping layer 7 has absorbed water, molecules of the cationic polymer are locked by each other through the crosslinking and work to highly suppress a change in the volume caused by swelling (absorption of water).

The crosslinked structure can be introduced by adding a crosslinking agent to the coating solution for forming the water trapping layer 7. Depending on the kind of the crosslinking agent, the crosslinked structure assumes a siloxane structure or a polyalicyclic structure to form a spatial mesh structure adapted to absorbing moisture. Specifically, the crosslinking agent in which the siloxane structure has been introduced works to improve close adhesion to the ALD film 5.

As the crosslinking agent, there can be used, for example, a compound having a crosslinking functional group (e.g., epoxy group) that is capable of reacting with the cationic group possessed by a cationic polymer, and a functional group (e.g., alkoxysilyl group) that is capable of forming a siloxane structure in the crosslinked structure through the hydrolysis and dehydration condensation. Specifically, there can be used a silane compound represented by the following formula (1):

$$X\text{-}SiR^1_n(OR^2)_{3-n} \qquad (1)$$

wherein, X is an organic group having an epoxy group at the terminal,
$R^1$ and $R^2$ are, respectively, methyl groups, ethyl groups or isopropyl groups, and
n is 0, 1 or 2.

The silane compound of the formula (1) has, as functional groups, an epoxy group and an alkoxysilyl group, the epoxy group undergoing the addition reaction with a functional group (e.g. , $NH_2$) of the cationic polymer. The alkoxysilyl group, on the other hand, forms a silanol group (SiOH group) through the hydrolysis and, through the condensation reaction, grows by forming the siloxane structure to, finally, form a crosslinked structure among the cationic polymer chains. Thus the crosslinked structure having the siloxane structure is introduced in the matrix of the cationic polymer. On the other hand, the silanol group formed by the hydrolysis of the alkoxysilyl group undergoes the dehydration condensation with the XOH group such as ZrOH group present on the surface of the ALD film 5 and strongly bonds thereto.

Besides, in the invention, the coating solution used for forming the water trapping layer 7 becomes alkaline and, as a result, accelerates the addition reaction of the cationic groups with the epoxy groups, and, further, accelerates the dehydration condensation among the silanol groups or the dehydration condensation of the silanol groups with the XOH groups on the surface of the ALD film 5.

Therefore, by using the compound of the above formula (1) as the crosslinking agent, it is allowed to introduce

the crosslinked structure in the matrix and, at the same time, to improve close adhesion to the ALD film 5 without using any particular adhesive.

In the invention, a $\gamma$-glycidoxyalkyl group is a representative example of the organic group X that has an epoxy group in the above formula (1). For instance, a $\gamma$-glycidoxypropyltrimethoxysilane and a $\gamma$-glycidoxypropylmethyldimethoxysilane can be favorably used as crosslinking agents.

There can be, also, favorably used a crosslinking agent of which the epoxy group in the above formula (1) is an alicyclic epoxy group such as epoxycyclohexyl group. For instance, if a compound having an alicyclic epoxy group such as $\beta$-(3,4,-epoxycyclohexyl)ethyltrimethoxysilane is used as the crosslinking agent, an alicyclic structure is introduced together with the siloxane structure in the crosslinked structure of the matrix. Introduction of the alicyclic structure makes it possible to further effectively express the function of the matrix which is to form a spatial mesh structure adapted to absorbing moisture.

In the invention, further, to introduce the alicyclic structure in the crosslinked structure, there can be used, as the crosslinking agent, a compound having a plurality of epoxy groups and an alicyclic epoxy group, for example, a diglycidyl ester represented by the following formula (2):

G-O(C=O)-A-(C=O)O-G (2)

wherein, G is a glycidyl group, and
A is a divalent hydrocarbon group having an alicyclic ring, such as cycloalkylene group.

A representative example of the diglycidyl ester is expressed by the following formula (2-1).

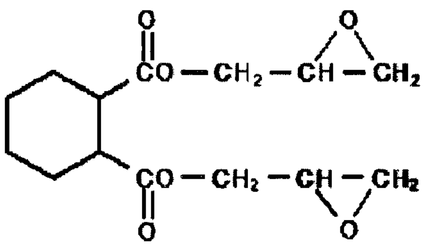

(2 − 1)

Namely, the diglycidyl ester of the formula (2-1) has no alkoxysilyl group and poorly works to improve close adhesion to the ALD film 5 but introduces the alicyclic structure in the crosslinked structure. Therefore, the diglycidyl ester of the formula (2-1) is effective in forming a spatial mesh structure in the matrix that is suited for absorbing moisture.

In the present invention, it is desired that the crosslinking agent is used in an amount of 5 to 60 parts by weight and, specifically, 15 to 50 parts by weight per 100 parts by weight of the cationic polymer, at least not less than 70% by weight and, preferably, not less than 80% by weight of the crosslinking agent being the silane compound of the above formula (1).

If the crosslinking agent is used in too large amounts, the mechanical strength becomes weak or brittle, handling becomes difficult, and the viscosity quickly increases when it is used to prepare a coating material making it, therefore, difficult to effectively maintain a pot life. If the crosslinking agent is used in too small amounts, on the other hand, it becomes difficult to maintain the withstanding property (e.g., mechanical strength) when exposed to severe environment (e.g., highly humid conditions). Further, if the silane compound of the above formula (1) is used at a small ratio, adhesiveness to the ALD film 5 decreases.

In the present invention, there is no particular limitation on the solvent used for the coating composition that contains the above-mentioned various components provided it can be volatilized and removed by the heating at a relatively low temperature. There can be used alcohol solvents such as methanol, ethanol, propyl alcohol and butanol; ketone solvents such as acetone and methyl ethyl ketone; mixed solvents of the above solvents with water; water; and aromatic hydrocarbon solvents such as benzene, toluene and xylene. Particularly desirably, however, there is used water or a mixed solvent that contains water to promote the hydrolysis of the silane compound that has the alkoxysilyl group in the crosslinking agent in the coating composition.

The above-mentioned solvents are used in such amounts that the coating composition assumes a viscosity adapted to being coated. It is, however, also allowable to add a non-ionic polymer in a suitable amount in order to adjust the viscosity of the coating composition or to adjust the coefficient of water absorption of the moisture absorbing matrix that is formed to lie in a suitable range.

As the non-ionic polymer, there can be exemplified saturated aliphatic hydrocarbon polymers such as polyvinyl alcohol, ethylene-propylene copolymer and polybutylene; styrene polymers such as styrene-butadiene copolymer; polyvinyl chloride; and those obtained by copolymerizing the above polymers with various comonomers (e.g. , styrene monomers like vinyltoluene, vinylxylene, chlorostyrene, chloromethylstyrene, $\alpha$-methylstyrene, $\alpha$-halogenated styrene and $\alpha$, $\beta$, $\beta$-trihalogenated styrene; monoolefins such as ethylene and butylene; and conjugated diolefins such as butadiene and isoprene).

In the present invention, the coating composition is applied to, for example, the surface of the ALD film 5, and is heated at about 80 to about 160°C for several seconds to several minutes depending on the capacity of an oven to remove the solvent. The crosslinking agent reacts with the cationic polymer or with the XOH groups on the surface of the ALD film 5 whereby the crosslinked structure is introduced in the matrix, and the water trapping layer 7 is formed having excellent adhesiveness to the ALD film 5.

There is no specific limitation on the thickness of the water trapping layer 7, and the thickness thereof can be suitably set depending on the use and the required degree of water barrier property. Usually, however, a thickness of at least not less than 1 $\mu$m and, specifically, about 2 to about 20 $\mu$m is enough for the water trapping layer 7 to exhibit super-barrier property such that the water vapor permeability is not more than $10^{-6}$ g/m$^2$/day.

Namely, as will be described later, the above-mentioned water trapping layer 7 has two functions, i.e. , absorbing water and confining water. Therefore, the above-mentioned super-barrier property against water is exhibited by forming a single water trapping layer 7 having a suitable thickness on the ALD film 5 on the inorganic oxide layer 3.

In the invention, further, it is desired that a moisture absorbing agent is dispersed in the water trapping layer 7 to, further, improve water barrier property. The moisture absorbing agent can, preferably, attain humidity which is lower than that by the cationic polymer, and, preferably, can attain a humidity of not more than 6% under an environmental condition of a humidity of 80%RH and a temperature of 30°C.

If the humidity attained by the moisture absorbing agent is higher than that attained by the cationic polymer, water absorbed by the moisture absorbing matrix is not confined therein to a sufficient degree permitting, therefore, water to be released. Therefore, a very high degree of water barrier property is not expected.

The moisture absorbing agent, usually, has a coefficient of water absorption (JIS K-7209-1984) of not less than 50% in an atmosphere of a humidity of 80%RH and a temperature of 30°C, and may be the agent of the inorganic type or the agent of the organic type.

Examples of the inorganic moisture absorbing agent include clay minerals such as zeolite, alumina, activated carbon and montmorillonite, as well as silica gel, calcium oxide, magnesium sulfide and the like.

Examples of the organic moisture absorbing agent include anionic polymer and a partly neutralized product thereof that is crosslinked. The anionic polymer may be those obtained by polymerizing at least any one of the anionic monomers represented by carboxylic acid monomers ((meth)acrylic acid, maleic acid anhydride, etc.), sulfonic acid monomers (halogenated vinylsulfonic acid, styrenesulfonic acid, vinylsulfonic acid, etc.), phosphonic acid monomers (vinylphosphonic acid, etc.) and salts of these monomers, or may be those obtained by copolymerizing at least any one of the above anionic monomers with other monomers. In the use where transparency is required, in particular, the organic moisture absorbing agent is effectively used. For instance, a fine particulate crosslinked sodium poly(meth)acrylate is a representative example of the organic moisture absorbing agent.

In the invention, the moisture absorbing agent having a small particle size (e.g., having a mean primary particle size $D_{50}$ of not more than 100 nm and, specifically, not more than 80 nm calculated as volume measured by the laser diffraction/scattering method) is preferred from the standpoint of attaining an increased specific surface area and improved moisture absorbing property. It is most desired to use the moisture absorbing agent of an organic polymer having a particularly small particle size.

That is, the moisture absorbing agent of an organic polymer can be very favorably dispersed in the matrix of a cationic polymer, i.e., can be homogeneously dispersed. Besides, the moisture absorbing agent can be produced by employing an emulsion polymerization or a suspension polymerization as the polymerization method. This also enables the moisture absorbing agent to be produced in a fine and neat spherical shape. By adding the moisture absorbing agent in an amount larger than a certain ratio, it is made possible to attain a very high degree of transparency. It is presumed that the transparency is brought about by the moisture absorbing agent which is in the form of very fine and spherical particles distributed in a laminar shape near the interface to the ALD film 5. Particularly, transparency gives a great advantage when the gas barrier laminate 10 is used as sealing layers or substrates of organic EL panels and the like.

The organic fine moisture absorbing agent can attain a very low humidity, exhibits high moisture absorbing property and undergoes a change in the volume very little despite it is swollen by crosslinking. Therefore, the organic moisture absorbing agent is best suited for lowering the humidity in the environmental atmosphere down to the absolutely dry state or to a level close to the absolutely dry state yet suppressing a change in the volume thereof.

As for fine particles of the organic moisture absorbing agent, fine particulate crosslinked sodium polyacrylate (mean particle size of about 70 nm) dispersed in a colloidal solution (pH = 10.4) has been placed in the market by Toyobo Co., Ltd. in the trade name of TAFTIC HU-820E. There can be also favorably used fine particles of crosslinked potassium

polyacrylate of which not less than 80% of the carboxyl groups have been neutralized with potassium salt.

In the present invention it is desired that the moisture absorbing agent is dispersed in an amount of not less than 50 parts by weight, specifically, 100 to 900 parts by weight and, more specifically, 200 to 600 parts by weight per 100 parts by weight of the cationic polymer from the standpoint of drawing its properties to a sufficient degree, greatly improving the water barrier property yet effectively suppressing a change in the size caused by the swelling, and maintaining the water barrier property that is higher than the barrier property exhibited by the inorganic oxide layer 3 for extended periods of time.

Here, the moisture absorbing agent may have been dispersed in a coating solution which is used for forming the water trapping layer 7.

<Use>

In the gas barrier laminate 10 of the present invention, the ALD film 5 works to improve barrier properties of the inorganic oxide layer 3 against water or oxygen. Besides, the gas barrier laminate 10 can be excellently produced and, therefore, can be preferably used as a film for sealing electronic circuits for various kinds of electronic devices such as organic EL devices, solar cells, electronic papers and the like. Further, if the base material 1 is made from a plastic film having excellent transparency, such as PET, PEN, polycarbonate or polyimide resin, then it is allowed to form transparent electrodes thereon and, further thereon, a light-emitting element such as an organic EL having a luminescent layer, or a photovoltaic element such as a solar cell.

EXAMPLES

Excellent properties of the gas barrier laminate of the invention will be described below by way of Experimental Examples.

<Measuring the MOH/MO ratio>

The MOH/MO ratio represents the quality of a film. The smaller the value, the less the defective bonds in the film which, therefore, is dense. The surface of the film formed on the base material is measured by using the Fourier transform infrared spectrophotometer, and from which the MOH/MO ratio is calculated.

Measurement of a silicon oxide film for its infrared absorption spectra by the differential spectral method showed infrared absorption peaks near 930 to 1060 $cm^{-1}$, and from which were found an absorption peak height (A1) of the SiOH group near a wavenumber 930 $cm^{-1}$ and an absorption peak height (A2) of the SiO group near a wavenumber 1060 $cm^{-1}$. An infrared absorbance ratio (A) of SiOH/SiO was found from A1/A2. An aluminum oxide film showed infrared absorption peaks near 950 to 1130 $cm^{-1}$, and from which were found an absorption peak height (B1) of the AlOH group near a wavenumber 1130 $cm^{-1}$ and an absorption peak height (B2) of the AlO group near a wavenumber 950 $cm^{-1}$. An infrared absorbance ratio (B) of AlOH/AlO was found from B1/B2.

<Measuring the film thickness and film density>

Based on the X-ray reflection factor analysis method, an X-ray was caused to be incident on the surface of the film at a very shallow angle to measure a profile of X-ray intensities reflected in the direction of mirror surface at an angle corresponding to the angle of incidence. The obtained profile was compared with the simulated results, and the simulation parameters were optimized to determine the film thickness and the film density.

<Measuring the water vapor barrier property>

The plastic base material on which the film has been formed was measured for its water vapor permeability ($H_2O$ permeability) at 40°C and 90%RH by using a water vapor permeability measuring apparatus (PERMATRAN-W 3/30 manufactured by Modern Controls, Inc.).

Water vapor permeabilities smaller than the measurable limit of the water vapor permeability measuring apparatus were measured by a method described below in compliance with the description of JP-A-2010-286285.

By using a vacuum evaporation apparatus (JEE-400 manufactured by JEOL Ltd.), a sample piece was prepared by vacuum-evaporating a thin Ca film (water-corrosive thin metal film) maintaining a thickness of 300 nm on the surface of an inorganic barrier layer of a sample gas barrier laminate and, further, vacuum-evaporating an Alfilm (water-impermeable thin metal layer) maintaining a thickness of 540 nm so as to cover the thin Ca film.

The thin Ca film was formed at six places in a circular shape each 1 mm in diameter by using metal calcium as a source of vapor evaporation and through a predetermined mask. The Al film was formed by vacuum evaporation

from a source of Al evaporation in the apparatus while removing the mask yet in vacuum.

The thus formed sample was fitted in a gas-impermeable cup filled with the silica gel (moisture absorbing capability of 300 mg/g) as the moisture absorbing agent. The sample was fixed therein by using a fixing ring and was used as a unit for evaluation.

The thus obtained unit for evaluation was held in an air-conditioned vessel adjusted to 40°C90% for 520 to 720 hours. Thereafter, by using a laser microscope (Laser Scan Microscope manufactured by Carl Zeiss), the unit for evaluation was observed in regard to if the thin Ca film was corroded, and the water vapor permeability was calculated from the amount the metal calcium has corroded. The water vapor permeability will often be represented as $H_2O$ permeability or initial moisture permeability.

<Evaluating the barrier effect of the ALD film>

The very thin metal oxide film (ALD film) 5 was deposited by the ALD method on the inorganic oxide layer of the gas barrier laminate to evaluate the barrier effect of the ALD film on the following basis.

○: The barrier property was doubled or more (water vapor permeability was not more than one-third) as compared to the barrier property calculated by a simple addition of the barrier property of the inorganic oxide layer and the barrier property of the ALD film.
◎: The barrier property was 10-fold or more (water vapor permeability was not more than one-tenth) as compared to the barrier property calculated by a simple addition of the barrier property of the inorganic oxide layer and the barrier property of the ALD film.
×: The barrier property was less than 2-fold (water vapor permeability was more than one-third) as compared to the barrier property calculated by a simple addition of the barrier property of the inorganic oxide layer and the barrier property of the ALD film.

<Evaluating the resistance of the ALD film against alkali>

Resistance of the ALD film against alkali was evaluated according to the procedure described below.

By using an X-ray flourescence spectrometer (ZSX100e manufactured by Rigaku Corporation), the PET film coated with the ALD film 5 was measured for the intensity of X-ray fluorescence due to the metal oxide on the ALD film 5.

The above PET film coated with the ALD film 5 was dipped in a 0.1 N sodium hydroxide aqueous solution maintained at 30°C for one hour. Thereafter, the PET film coated with the ALD film 5 was similarly measured for the intensity of X-ray fluorescence due to the metal oxide on the ALD film 5.

A reduction ratio (X)% after the ALD film 5 was dipped in the alkali aqueous solution was calculated according to the following formula,

$$(X) = 100 - ((2)/(1) \times 100)$$

The evaluation was made on the following basis.

◎: The reduction ratio was not more than 0.03%.
○: The reduction ratio was more than 0.03% but was less than 0.05%.
×: The reduction ratio was not less than 0.05%.

<Evaluating the attained humidity>

Humidities attained by using the cationic polymer and the moisture absorbing agent were measured by a method described below.

After dried at 140°C for one hour, 0.5 g of the material to be measured and a wireless thermometer/hygrometer (Hygrochron, manufactured by KN Laboratories, Inc.) were put into a cup laminated with a water-impermeable steel-foil and having a volume of 85 $cm^3$ in an atmosphere of 30°C80RH. The mouth of the container was heat-sealed with a lid of an aluminum foil-laminated film. After left to stand at 30°C for one day, the relative humidity in the container was regarded as the attained humidity.

<Evaluating the deterioration of water barrier property with the passage of time>

The sample gas barrier laminate was stored in an air-conditioned oven adjusted at 85°C for 7 days continuously. Thereafter, the water vapor permeability (moisture permeability after deteriorated with the passage of time) was calculated by the above-mentioned method of measuring the water vapor permeability, and was evaluated in the same manner as the water vapor permeability (initial moisture permeability) of before being stored.

<Experiment 1>

The following Examples and Comparative Examples were carried out in order to evaluate the effect for improving barrier property of the gas barrier laminates having the structure of layers shown in Fig. 1.

(Example 1-1)

Forming the film of silicon oxide (inorganic oxide layer);

A CVD apparatus having the following specifications was used for forming the films.

High-frequency power source: frequency of 27.12 MHz,
maximum output of 2 kW.
Matching box.
Cylindrical plasma film-forming metal chamber:
300 mm in diameter, 450 mm in height Vacuum pump for evacuating the film-forming chamber. As the plastic base material, there was used a polyethylene terephthalate (PET) film of a square shape of a side of 120 mm and 100 μm in thickness.

The PET film was set on a feeder electrode in the film-forming chamber in the CVD apparatus. While evacuating the interior of the chamber from an exhaust port by using the vacuum pump, hexamethyldisiloxane was introduced at a rate of 3 sccm and oxygen was introduced at a rate of 45 sccm as staring gases through a gas blow-out port near the feeder electrode. Thereafter, a high-frequency output of 300 W was generated by the high-frequency oscillator, and a plasma treatment was executed for 50 seconds to form a silicon oxide film on one surface of the PET film.

ALD film of zirconium oxide (very thin metal oxide film);

After the silicon oxide film was formed on the surface of the PET film, an argon gas was introduced into the vacuum film-forming chamber at a rate of 60 sccm for 5 seconds to purge excess of gases at the time of forming the silicon oxide film.

Thereafter, as the starting gas, a zirconium tetratertiary butoxide was introduced at a rate of 20 sccm for 2 seconds together with the argon gas that is the carrier gas (rate of feeding the starting materials was 0.01 g/min. excluding the carrier gas).

Next, the argon gas was introduced at 60 sccm for 5 seconds to purge the interior of the vacuum film-forming chamber and, thereafter, water vapor was introduced as the reaction gas at a rate of 10 sccm for 2 seconds. The operation of up to this point was regarded to be one cycle of ALD. The operation was repeated a total of 20 cycles to obtain a gas barrier laminate, i.e. , a PET film having the silicon oxide layer and a very thin ALD film of zirconium oxide (very thin Zr oxide layer) equivalent to 20 atomic layers thereon.

(Example 1-2)

A gas barrier laminate was obtained in the same manner as in Example 1-1 but introducing, as the starting gas, an ammonia gas at a rate of 10 sccm in addition to the above-mentioned gases in the step of forming the silicon oxide film to thereby form a silicon oxynitride layer.

(Example 1-3)

A gas barrier laminate was obtained in the same manner as in Example 1-1 but forming the ALD film (very thin Zn oxide layer) by using diethylzinc as the starting gas for ALD.

(Example 1-4)

A gas barrier laminate was obtained in the same manner as in Example 1-1 but forming the ALD film (very thin Ti oxide layer) by using tetrakisdimethylaminotitanium as the starting gas for ALD.

(Example 1-5)

A gas barrier laminate was obtained in the same manner as in Example 1-1 but forming the ALD film (very thin Hf oxide layer) by using tetrakisethylmethylaminohafnium as the starting gas for ALD.

(Example 1-6)

A gas barrier laminate was obtained in the same manner as in Example 1-1 but setting the output of the high-frequency oscillator to be 100W in the step of forming the silicon oxide film.

(Example 1-7)

A gas barrier laminate was obtained in the same manner as in Example 1-1 but repeating the ALD cycle 80 times in the step of forming the ALD film (very thin Zr oxide layer).

(Example 1-8)

A gas barrier laminate was obtained in the same manner as in Example 1-1 but repeating the ALD cycle 5 times in the step of forming the ALD film (very thin Zr oxide layer).

(Example 1-9)

A gas barrier laminate was obtained in the same manner as in Example 1-1 but executing the plasma treatment for 10 seconds in the step of forming the silicon oxide film and repeating the ALD cycle 2 times in the step of forming the very thin zirconium oxide film.

(Example 1-10)

Forming the film of aluminum oxide;

A high-frequency magnetron sputtering apparatus equipped with the following parts was used for forming the films.

High-frequency power source: frequency of 27.12 MHz,
maximum output of 2 kW.
Matching box.
Cylindrical plasma film-forming metal chamber:
300 mm in diameter, 450 mm in height
Vacuum pump for evacuating the film-forming chamber.

As the plastic base material, there was used the same PET film as the one used in Example 1.
An aluminum target was set on the feeder electrode in the film-forming chamber, and the PET film was set on the opposing electrode. While evacuating the interior of the chamber from the exhaust port by using the vacuum pump, an argon gas was introduced at a rate of 100 sccm and oxygen was introduced at a rate of 25 sccm through the gas blow-out port near the feeder electrode. Thereafter, a high-frequency output of 300 W was generated by the high-frequency oscillator, and a sputtering treatment was executed for 300 seconds to form an aluminum oxide film on one surface of the PET film.

Forming the ALD film (very thin Zr oxide layer);

After the aluminum oxide film was formed on the base material, an argon gas was introduced into the vacuum film-forming chamber at a rate of 60 sccm for 5 seconds to purge excess of gases at the time of forming the aluminum oxide film.

Thereafter, as the starting gas, a zirconium tetratertiary butoxide was introduced at a rate of 20 sccm for 2 seconds together with the argon gas that is the carrier gas (rate of feeding the starting materials was 0.01 g/min. excluding the carrier gas).

Next, the argon gas was introduced at a rate of 60 sccm for 5 seconds to purge the interior of the vacuum film-forming chamber and, thereafter, water vapor was introduced as the reaction gas at a rate of 10 sccm for 2 seconds. The operation of up to this point was regarded to be one cycle of ALD. The operation was repeated a total of 20 cycles to obtain a gas barrier laminate, i.e., a PET film having the aluminum oxide layer and a very thin zirconium oxide layer equivalent to 20 atomic layers thereon.

(Example 1-11)

A gas barrier laminate was obtained in the same manner as in Example 1-1 but forming the very thin aluminum oxide film by using trimethylaluminum as the starting gas for ALD.

(Comparative Example 1-1)

A gas barrier laminate was obtained in the same manner as in Example 1-1 but repeating the ALD cycle 100 times in the step of forming the very thin zirconium oxide film.

(Comparative Example 1-2)

A gas barrier laminate was obtained in the same manner as in Example 1-1 but executing the plasma treatment for 100 seconds in the step of forming the silicon oxide film and repeating the ALD cycle 5 times in the step of forming the very thin zirconium oxide film.

The gas barrier laminates obtained above were measured for properties and water vapor permeabilities (water barrier properties) of the layers. Water vapor permeabilities calculated from the laminates were compared with water vapor permeabilities that were measured to evaluate the effects of the ALD for improving barrier properties. The results were as shown in Table 1.

Table 1

| | Inorganic oxide layer 3 | | | | Very thin metal oxide layer 5 | | | |
|---|---|---|---|---|---|---|---|---|
| | | Thickness d1 | MOH/MO | $H_2O$ permeability ($g/m^2 \cdot day$) | | Density $g/cm^3$ | Thickness d2 | $H_2O$ Permeability ($g/m^2 \cdot day$) |
| EX. 1-1 | $SiO_x$ | 42 nm | 0.06 | $8.4 \times 10^{-3}$ | $ZrO_2$ | 5.7 | 4.1 nm | $5.3 \times 10^{-2}$ |
| EX. 1-2 | $SiO_XN_y$ | 46 nm | 0.1 | $5.0 \times 10^{-3}$ | $ZrO_2$ | 5.7 | 4.1 nm | $5.3 \times 10^{-2}$ |
| EX. 1-3 | $SiO_x$ | 42 nm | 0.06 | $8.4 \times 10^{-3}$ | ZnO | 5.6 | 4.0 nm | $9.0 \times 10^{-2}$ |
| EX. 1-4 | $SiO_x$ | 42 nm | 0.06 | $8.4 \times 10^{-3}$ | $TiO_2$ | 4.2 | 3.8 nm | $1.5 \times 10^{-1}$ |
| EX. 1-5 | $SiO_x$ | 42 nm | 0.06 | $8.4 \times 10^{-3}$ | $HfO_2$ | 9.7 | 4.6 nm | $3.1 \times 10^{-2}$ |
| EX. 1-6 | $SiO_x$ | 45 nm | 0.14 | $5.1 \times 10^{-2}$ | $ZrO_2$ | 5.7 | 4.1 nm | $5.3 \times 10^{-2}$ |
| EX. 1-7 | $SiO_x$ | 42 nm | 0.06 | $8.4 \times 10^{-3}$ | $ZrO_2$ | 5.7 | 13.9 nm | $7.9 \times 10^{-3}$ |
| EX. 1-8 | $SiO_x$ | 42 nm | 0.06 | $8.4 \times 10^{-3}$ | $ZrO_2$ | 5.7 | 0.9 nm | $5.0 \times 10^{-1}$ |
| EX. 1-9 | $SiO_x$ | 10 nm | 0.06 | $3.8 \times 10^{-2}$ | $ZrO_2$ | 5.7 | 0.4 nm | $1.3 \times 10^{0}$ |

(continued)

| | Inorganic oxide layer 3 | | | | Very thin metal oxide layer 5 | | | |
|---|---|---|---|---|---|---|---|---|
| | | Thickness d1 | MOH/MO | $H_2O$ permeability ($g/m^2 \cdot day$) | | Density $g/cm^3$ | Thickness d2 | $H_2O$ Permeability ($g/m^2 \cdot day$) |
| EX. 1-10 | $Al_2O_x$ | 50 nm | 0.01 | $9.4 \times 10^{-3}$ | $ZrO_2$ | 5.7 | 4.1 nm | $5.3 \times 10^{-2}$ |
| EX. 1-11 | $SiO_x$ | 42 nm | 0.06 | $8.4 \times 10^{-3}$ | $Al_2O_3$ | 4.0 | 3.2 nm | $1.1 \times 10^{-1}$ |
| Com. 1-1 | $SiO_x$ | 42 nm | 0.06 | $8.4 \times 10^{-3}$ | $ZrO_2$ | 5.7 | 20.2 nm | $8.1 \times 10^{-4}$ |
| Com. 1-2 | $SiO_x$ | 90 nm | 0.06 | $1.9 \times 10^{-3}$ | $ZrO_2$ | 5.7 | 0.9 nm | $5.0 \times 10^{-1}$ |

| | d1/d2 | Calculated $H_2O$ permeability ($g/m^2 \cdot day$) | Measured $H_2O$ permeability ($g/M^2 \cdot day$) | Barrier property improved by ALD |
|---|---|---|---|---|
| EX. 1-1 | 10 | $7.3 \times 10^{-3}$ | $4.2 \times 10^{-4}$ | ◎ |
| EX. 1-2 | 11 | $4.6 \times 10^{-3}$ | $3.5 \times 10^{-4}$ | ◎ |
| EX. 1-3 | 11 | $7.7 \times 10^{-3}$ | $8.5 \times 10^{-4}$ | ○ |
| EX. 1-4 | 11 | $8.0 \times 10^{-3}$ | $5.8 \times 10^{-4}$ | ◎ |
| EX. 1-5 | 9 | $6.6 \times 10^{-3}$ | $2.8 \times 10^{-4}$ | ◎ |
| EX. 1-6 | 11 | $2.6 \times 10^{-2}$ | $5.5 \times 10^{-3}$ | ○ |
| EX. 1-7 | 3 | $4.1 \times 10^{-3}$ | $4.0 \times 10^{-4}$ | ◎ |
| EX. 1-8 | 47 | $8.3 \times 10^{-3}$ | $3.2 \times 10^{-3}$ | ○ |
| EX. 1-9 | 25 | $3.7 \times 10^{-2}$ | $3.8 \times 10^{-3}$ | ○ |
| EX. 1-10 | 12 | $8.0 \times 10^{-3}$ | $9.1 \times 10^{-4}$ | ○ |
| EX. 1-11 | 14 | $7.9 \times 10^{-3}$ | $3.3 \times 10^{-3}$ | ○ |
| Com. 1-1 | 2 | $7.4 \times 10^{-4}$ | $3.9 \times 10^{-4}$ | × |
| Com. 1-2 | 90 | $1.9 \times 10^{-3}$ | $9.5 \times 10^{-4}$ | × |

<Experiment 2>

The following Examples and Comparative Examples were for evaluating the barrier properties of when the water trapping layer containing the cationic material was formed on the ALD layer.

(Example 2-1)

Preparation of gas barrier laminates having the structure of layers shown in Fig. 3;

A silicon oxide layer 3 (42 nm thick) and an ALD film 5 of zirconium oxide (4.1 nm thick) were formed on one surface of the PET film 1 in quite the same manner as in Example 1-1 conducted in Experiment 1.

On the other hand, as the cationic polymer, a polyallylamine (PAA-15C produced by Nittobo Medical Co., Ltd., aqueous solution, solid content of 15%) was diluted with water such that the solid content thereof was 5% by weight to prepare a polymer solution.

Further, as the crosslinking agent, a γ-glycidoxypropyltrimethoxysilane was dissolved in water such that the amount thereof was 5% by weight to prepare a crosslinking agent solution.

Next, the polymer solution and the crosslinking agent solution were mixed together such that the amount of the γ-glycidoxypropyltrimethoxysilane was 20 parts by weight relative to 100 parts by weight of the polyallylamine. To the mixed solution was, further, added, as the moisture absorbing agent, a crosslinked product of sodium polyacrylate in an amount of 420 parts by weight relative to the polyallylamine followed by the addition of water such that the solid content thereof was adjusted to be 5%. The mixture was stirred well to prepare a coating solution for forming the water trapping layer.

As the crosslinked product of the sodium polyacrylate, there was used the TAFTIC HU-820E produced by Toyobo Co. , Ltd. (water dispersion, solid content of 13%, mean particle size $D_{50}$: 7 0 nm).

By using a bar coater, the thus obtained coating solution was applied onto the ALD film on the PET film that has been formed in advance. The film after coated with the coating solution was heat-treated in a box-type electric oven under the conditions of a peak temperature of 120°C and a peak temperature-holding time of 10 seconds to obtain a coated film having a water trapping layer 7 formed thereon in a thickness of 4 μm.

Next, in a glove box in which the nitrogen concentration was adjusted to be not less than 99.95%, a PET film of a thickness of 12 μm on which one surface has been formed a silicon oxide film 3 (water vapor permeability at 40°C90%RH: 0.1 g/m$^2$/day) was dry-laminated on the water trapping layer 7 of the above coated film via an adhesive resin layer 8 of an urethane adhesive of a thickness of 4 μm in a manner that the silicon oxide film 3 was on the outer side. In order to cure the adhesive resin layer 8 so will not to absorb moisture, the laminate was aged in vacuum at 50°C for 3 days to obtain a gas barrier laminate structure 11 having a structure of layers as shown in Fig. 3.

<Example 2-2>

A gas barrier laminate structure 11 was obtained in the same manner as in Example 2-1 but forming the ALD film 5 using a tetrakisdimethylaminotitanium as the ALD starting gas.

<Example 2-3>

A gas barrier laminate structure 11 was obtained in the same manner as in Example 2-1 but forming the ALD film 5 using a tetrakisethylmethylaminohafnium as the ALD starting gas.

<Example 2-4>

A gas barrier laminate structure 11 was obtained in the same manner as in Example 2-1 but forming the ALD film 5 using a trimethylaluminum as the ALD starting gas.

<Example 2-5>

A gas barrier laminate structure 11 was obtained in the same manner as in Example 2-1 but setting the output of the high-frequency oscillator to 100 W in the step of forming the silicon oxide film.

<Example 2-6>

A gas barrier laminate structure 11 was obtained in the same manner as in Example 2-1 but setting the plasma-treatment time to 100 seconds in the step of forming the silicon oxide film, and forming the ALD film 5 by repeating the ALD cycle 5 times in the step of forming the ALD film.

<Example 2-7>

A gas barrier laminate structure 11 was obtained in the same manner as in Example 2-1 but forming the ALD film 5 by repeating the ALD cycle 100 times in the step of forming the ALD film.

<Example 2-8>

A gas barrier laminate structure 11 was obtained in the same manner as in Example 2-1 but repeating the ALD cycle 80 times in the step of forming the ALD film.

<Example 2-9>

A gas barrier laminate structure 11 was obtained in the same manner as in Example 2-1 but repeating the ALD cycle 45 times in the step of forming the ALD film.

<Example 2-10>

A gas barrier laminate structure 11 was obtained in the same manner as in Example 2-1 but repeating the ALD cycle 5 times in the step of forming the ALD film.

<Example 2-11>

A gas barrier laminate structure 11 was obtained in the same manner as in Example 2-1 but setting the plasma-treatment time to 10 seconds in the step of forming the silicon oxide film, and repeating the ALD cycle 2 times in the step of forming the ALD film.

<Example 2-12>

A gas barrier laminate structure 11 was obtained in the same manner as in Example 2-1 but forming the water trapping layer 7 by adding the moisture absorbing agent in an amount of 50 parts by weight relative to the polyallylamine.

<Example 2-13>

A gas barrier laminate structure 11 was obtained in the same manner as in Example 2-1 but forming the water trapping layer 7 by adding the moisture absorbing agent in an amount of 1000 parts by weight relative to the polyallylamine.

<Example 2-14>

A gas barrier laminate structure 11 was obtained in the same manner as in Example 2-1 but forming the water trapping layer 7 by mixing the polymer solution and the crosslinking agent solution in a manner that the amount of the γ-glycidoxypropyltrimethoxysilane which is the crosslinking agent was 7 parts by weight relative to the polyallylamine and, further, by adding the moisture absorbing agent in an amount of 375 parts by weight relative to the polyallylamine.

<Example 2-15>

A gas barrier laminate structure 11 was obtained in the same manner as in Example 2-1 but forming the water trapping layer 7 by mixing the polymer solution and the crosslinking agent solution in a manner that the amount of the γ-glycidoxypropyltrimethoxysilane which is the crosslinking agent was 50 parts by weight relative to the polyallylamine and, further, by adding the moisture absorbing agent in an amount of 525 parts by weight relative to the polyallylamine.

<Example 2-16>

A gas barrier laminate structure 11 was obtained in the same manner as in Example 2-1 but forming the water trapping layer 7 by adding no γ-glycidoxypropyltrimethoxysilane which is the crosslinking agent, and adding the moisture absorbing agent in an amount of 150 parts by weight relative to the polyallylamine.

<Example 2-17>

A gas barrier laminate structure 11 was obtained in the same manner as in Example 2-1 but forming the water trapping layer 7 by using a polyethyleneimine (Polyethyleneimine 10000 produced by Junsei Chemical Co., Ltd.) as the cationic polymer.

<Example 2-18>

A gas barrier laminate structure 11 was obtained in the same manner as in Example 2-1 but forming the water trapping layer 7 by using a β -(3,4-epoxycyclohexyl)ethyltrimethoxysilane as the crosslinking agent.

<Example 2-19>

A gas barrier laminate structure 11 was obtained in the same manner as in Example 2-1 but forming the water trapping layer 7 by mixing the polymer solution and the crosslinking agent solution in a manner that the amount of the γ-glycidoxypropyltrimethoxysilane which is the crosslinking agent was 16 parts by weight relative to the polyallylamine and, further, by adding a diglycidyl 1,2-cyclohexanedicarboxylate as the crosslinking agent in an amount of 4 parts by weight relative to the polyallylamine.

<Example 2-20>

A gas barrier laminate structure 11 was obtained in the same manner as in Example 2-1 but forming the water trapping layer 7 by using a water/acetone mixed solvent (at a weight ratio of 80/20) instead of water as the solvent of the coating solution, adding, as the crosslinking agent, a diglycidyl 1, 2-cyclohexanedicarboxylate in an amount of 20 parts by weight per 100 parts by weight of the polyallylamine and, further, adding the moisture absorbing agent in an amount of 180 parts by weight relative to the polyallylamine.

<Example 2-21>

By using an ion-exchange resin (Amberlite 200CT produced by Organo Corp.), the sodium salt-type carboxyl groups in the crosslinked product (HU-820E) of the sodium polyacrylate were converted into the H-type carboxyl groups. Thereafter, by using a 1N aqueous solution of potassium hydroxide, there was obtained a crosslinked product of potassium polyacrylate having the potassium salt-type carboxyl groups (water dispersion, solid content 10%, average particle size $D_{50}$: 70 nm, neutralization degree 80%).

A gas barrier laminate structure 11 was obtained in the same manner as in Example 2-1 but forming the water trapping layer 7 by using the crosslinked product of the potassium polyacrylate as the moisture absorbing agent.

<Comparative Example 2-1>

A gas barrier laminate structure 11 was obtained in the same manner as in Example 2-1 but forming no ALD film 5.

<Comparative Example 2-2>

A gas barrier laminate structure 11 was obtained in the same manner as in Example 2-1 but forming no ALD film 5 in Example 2-6.

<Comparative Example 2-3>

A gas barrier laminate structure 11 was obtained in the same manner as in Example 2-1 but forming no ALD film 5 in Example 2-7.

<Comparative Example 2-4>

A gas barrier laminate structure 11 was obtained in the same manner as in Example 2-1 but forming no ALD film 5 in Example 2-12.

The gas barrier laminate structures 11 prepared in the above Examples and Comparative Examples possessed the structures of layers as shown in Tables 2 and 3, and were evaluated for their properties by the above-mentioned methods as shown in Tables 4 and 5.

In Tables, Ex. represents Examples and Com. represents Comparative Examples.

Further, abbreviations of the materials are as described below.

C-Polymer: cationic polymer
K-PolyAc: crosslinked particles of K salt-type polyacrylic acid
γ-GPrTMS: γ-glycidoxypropyltrimethoxysilane
β-EpCyEtTMS: β-(3,4-epoxycyclohexyl)ethyltrimethoxysilane
1,2-CyDCADG: diglycidyl 1,2-cyclohexanedicarboxylate

In Tables, the amounts of the moisture absorbing agent are per 100 parts by weight of the cationic polymer.

Table 2

| | *1 | | | ALD film | | | Water trapping layer | | | | | |
|---|---|---|---|---|---|---|---|---|---|---|---|---|
| | | d1 (nm) | *2 | | d2 (nm) | d1/ d2 | *3 | *4 | *5 | *6 | *7 | *8 |
| Ex.2-1 | $SiO_x$ | 42 | 0.06 | $ZrO_2$ | 4.1 | 10 | polyallylamine (100) | 7.1 | HU-820E (420) | 0.0 | γ-GPrTMS (20) | 4.0 |
| Ex.2-2 | $SiO_x$ | 42 | 0.06 | $TiO_2$ | 3.8 | 11 | polyallylamine (100) | 7.1 | HU-820E (420) | 0.0 | γ-GPrTMS (20) | 4.0 |
| Ex.2-3 | SiOx | 42 | 0.06 | $HfO_2$ | 4.6 | 9 | polyallylamine (100) | 7.1 | HU-820E (420) | 0.0 | γ-GPrTMS (20) | 4.0 |
| Ex.2-4 | SiOx | 42 | 0.06 | $Al_2O_3$ | 3.2 | 13 | polyallylamine (100) | 7.1 | HU-820E (420) | 0.0 | γ-GPrTMS (20) | 4.0 |
| Ex.2-5 | $SiO_x$ | 42 | 0.14 | $ZrO_2$ | 4.1 | 10 | polyallylamine (100) | 7.1 | HU-820E (420) | 0.0 | γ-GPrTMS (20) | 4.0 |
| Ex.2-6 | $SiO_x$ | 90 | 0.06 | $ZrO_2$ | 1.0 | 90 | polyallylamine (100) | 7.1 | HU-820E (420) | 0.0 | γ-GPrTMS (20) | 4.0 |
| Ex.2-7 | SiOx | 42 | 0.06 | $ZrO_2$ | 20.2 | 2 | polyallylamine (100) | 7.1 | HU-820E (420) | 0.0 | γ-GPrTMS (20) | 4.0 |
| Ex.2-8 | SiOx | 42 | 0.06 | $ZrO_2$ | 13.9 | 3 | polyallylamine (100) | 7.1 | HU-820E (420) | 0.0 | γ-GPrTMS (20) | 4.0 |
| Ex.2-9 | SiOx | 42 | 0.06 | $ZrO_2$ | 9.8 | 4 | polyallylamine (100) | 7.1 | HU-820E (420) | 0.0 | γ-GPrTMS (20) | 4.0 |
| Ex.2-10 | $SiO_x$ | 42 | 0.06 | $ZrO_2$ | 0.9 | 47 | polyallylamine (100) | 7.1 | HU-820E (420) | 0.0 | γ-GPrTMS (20) | 4.0 |
| Ex.2-11 | SiOx | 10 | 0.06 | $ZrO_2$ | 0.4 | 25 | polyallylamine (100) | 7.1 | HU-820E (420) | 0.0 | γ-GPrTMS (20) | 4.0 |
| Ex.2-12 | $SiO_x$ | 42 | 0.06 | $ZrO_2$ | 4.1 | 10 | polyallylamine (100) | 7.1 | HU-820E (50) | 0.0 | γ-GPrTMS (20) | 4.0 |
| Ex.2-13 | $SiO_x$ | 42 | 0.06 | $ZrO_2$ | 4.1 | 10 | polyallylamine (100) | 7.1 | HU-820E (1000) | 0.0 | γ-GPrTMS (20) | 4.0 |

*1: Inorganic oxide layer, *2: SiOH/SiO,
*3: C-Polymer (amount), *4: C-Polymer Attained humidity (%RH),
*5: Moist absorber (amount), *6: Moist absorber, attained humidity (%RH),
*7: Crosslinking agent (amount),
*8: Thickness (μm)

Table 3

| | *1 | | | ALD film | | | Water trapping layer | | | | | |
|---|---|---|---|---|---|---|---|---|---|---|---|---|
| | | d1 (nm) | *2 | | d2 (nm) | d1/ d2 | *3 | *4 | *5 | *6 | *7 | *8 |
| Ex.2-14 | SiOx | 42 | 0.06 | $ZrO_2$ | 4.1 | 10 | polyallylamine (100) | 7.1 | HU-820E (375) | 0.0 | γ-GPrTMS (7) | 4.0 |
| Ex.2-15 | SiOx | 42 | 0.06 | $ZrO_2$ | 4.1 | 10 | polyallylamine (100) | 7.1 | HU-820E (525) | 0.0 | γ-GPrTMS (50) | 4.0 |
| Ex.2-16 | SiOx | 42 | 0.06 | $ZrO_2$ | 4.1 | 10 | polyallylamine (100) | 7.1 | HU-820E (180) | 0.0 | | 4.0 |
| Ex.2-17 | SiOx | 42 | 0.06 | $ZrO_2$ | 4.1 | 10 | polyethyleneimine (100) | 7.3 | HU-820E (420) | 0.0 | γ-GPrTMS (20) | 4.0 |
| Ex.2-18 | SiOx | 42 | 0.06 | $ZrO_2$ | 4.1 | 10 | polyallylamine (100) | 7.1 | HU-820E (420) | 0.0 | β-EpcyEtTMS (20) | 4.0 |
| Ex.2-19 | SiOx | 42 | 0.06 | $ZrO_2$ | 4.1 | 10 | polyallylamine (100) | 7.1 | HU-820E (420) | 0.0 | γ-GPrTMS (16) 1,2-CyDCAG (4) | 4.0 |
| Ex.2-20 | SiOx | 42 | 0.06 | $ZrO_2$ | 4.1 | 10 | polyallylamine (100) | 7.1 | HU-820E (180) | 0.0 | 1,2-CyDCAG (20) | 4.0 |
| Ex.2-21 | SiOx | 42 | 0.06 | $ZrO_2$ | 4.1 | 10 | polyallylamine (100) | 7.1 | K-PolyAc (420) | 0.0 | γ-GPrTMS (20) | 4.0 |
| Com.2-1 | SiOx | 42 | 0.06 | - | - | - | polyallylamine (100) | 7.1 | HU-820E (420) | 0.0 | γ-GPrTMS (20) | 4.0 |
| Com.2-2 | SiOx | 42 | 0.14 | - | - | - | polyallylamine (100) | 7.1 | HU-820E (420) | 0.0 | γ-GPrTMS (20) | 4.0 |
| Com.2-3 | $SiO_x$ | 90 | 0.06 | - | - | - | polyallylamine (100) | 7.1 | HU-820E (420) | 0.0 | γ-GPrTMS (20) | 4.0 |
| Com.2-4 | SiOx | 10 | 0.06 | - | - | - | polyallylamine (100) | 7.1 | HU-820E (420) | 0.0 | γ-GPrTMS (20) | 4.0 |

*1: Inorganic oxide layer, *2: SiOH/SiO,
*3: C-Polymer (amount), *4: C-Polymer Attained humidity (%RH),
*5: Moist absorber (amount), *6: Moist absorber, attained humidity (%RH),
*7: Crosslinking agent (amount),
*8: Thickness (μm)

Table 4

| | Reduction of alkali resistance of ALD film (%) | Initial moisture permeability ($g/m^2/day$) | Moisture permeability after aged ($g/m^2/day$) |
|---|---|---|---|
| Ex.2-1 | ◎ (0.026) | ◎ (≦$10^{-5}$) | ◎ (≦$10^{-5}$) |
| Ex.2-2 | ◎ (0.029) | ◎ (≦$10^{-5}$) | ◎ (≦$10^{-5}$) |
| Ex.2-3 | ◎ (0.021) | ◎ (≦$10^{-5}$) | ◎ (≦$10^{-5}$) |
| Ex.2-4 | ○ (0.049) | ◎ (≦$10^{-5}$) | ◎ (≦$10^{-5}$) |
| Ex.2-5 | ◎ (0.026) | (≦$10^{-5}$) | (≦$10^{-5}$) |
| Ex.2-6 | ◎ (0.026) | ◎ (≦$10^{-5}$) | ◎ (≦$10^{-5}$) |
| Ex.2-7 | ◎ (0.023) | ◎ (≦$10^{-5}$) | ◎ (≦$10^{-5}$) |
| Ex.2-8 | ◎ (0.025) | ◎ (≦$10^{-5}$) | ◎ (≦$10^{-5}$) |
| Ex.2-9 | ◎ (0.025) | ◎ (≦$10^{-5}$) | ◎ (≦$10^{-5}$) |
| Ex.2-10 | ◎ (0.030) | ◎ (≦$10^{-5}$) | ◎ (≦$10^{-5}$) |
| Ex.2-11 | ○ (0.032) | ◎ (≦$10^{-5}$) | ◎ (≦$10^{-5}$) |
| Ex.2-12 | ◎ (0.026) | ◎ (≦$10^{-5}$) | ◎ (≦$10^{-5}$) |
| Ex.2-13 | ◎ (0.026) | ◎ (≦$10^{-5}$) | ◎ (≦$10^{-5}$) |

Table 5

| | Reduction of alkali resistance of ALD film (%) | Initial moisture permeability ($g/m^2/day$) | Moisture permeability after aged ($g/m^2/day$) |
|---|---|---|---|
| Ex.2-14 | ◎ (0.026) | ◎ (≦$10^{-5}$) | ◎ (≦$10^{-5}$) |
| Ex.2-15 | ◎ (0.026) | ◎ (≦$10^{-5}$) | ◎ (≦$10^{-5}$) |
| Ex.2-16 | ◎ (0.026) | ◎ (≦$10^{-5}$) | ◎ (≦$10^{-5}$) |
| Ex.2-17 | ◎ (0.026) | ◎ (≦$10^{-5}$) | ◎ (≦$10^{-5}$) |
| Ex.2-18 | ◎ (0.026) | ◎ (≦$10^{-5}$) | ◎ (≦$10^{-5}$) |
| Ex.2-19 | ◎ (0. 026) | ◎ (≦$10^{-5}$) | ◎ (≦$10^{-5}$) |
| Ex.2-20 | ◎ (0.026) | ◎ (≦$10^{-5}$) | ◎ (≦$10^{-5}$) |
| Ex.2-21 | ◎ (0.026) | ◎ (≦$10^{-5}$) | ◎ (≦$10^{-5}$) |
| Com.2-1 | - | ◎ (≦$10^{-5}$) | × (≦$10^{-3}$) |
| Com.2-2 | - | ○ (≦$10^{-3}$) | × ($10^{-1}$) |
| Com.2-3 | - | ◎ (≦$10^{-5}$) | × ($10^{-3}$) |
| Com.2-4 | - | ○ (≦$10^{-3}$) | × ($10^{-1}$) |

Description of Reference Numerals

1: Plastic base material
3: Inorganic oxide layer
5: ALD film (very thin metal oxide film formed by the atomic layer deposition method)
7: Water trapping layer
10: Gas barrier laminate

## Claims

1. A gas barrier laminate having a very thin metal oxide film formed on an inorganic oxide layer by an atomic layer deposition method, said inorganic oxide layer including a metal oxide or a metal oxynitride that contains at least either Si or Al, and a ratio (d1/d2) of a thickness d1 of said inorganic oxide layer and a thickness d2 of the very thin metal oxide film being 3 to 50.

2. The gas barrier laminate according to claim 1, wherein said very thin metal oxide film has a thickness d2 in a range of 0.5 to 9 nm.

3. The gas barrier laminate according to claim 1, wherein said very thin metal oxide has a density of not less than 4.2 $g/cm^3$.

4. The gas barrier laminate according to claim 1, wherein said inorganic oxide layer is formed on a plastic base material.

5. The gas barrier laminate according to claim 1, wherein said inorganic oxide layer has an MOH/MO ratio (M is Si or Al) of not more than 0.1.

6. The gas barrier laminate according to claim 1, wherein said very thin metal oxide film contains Ti, Zr, Hf or Al.

7. The gas barrier laminate according to claim 1, wherein said inorganic oxide layer includes an oxide that contains Si, and a cationic material is formed on said very thin metal oxide film.

Fig. 1

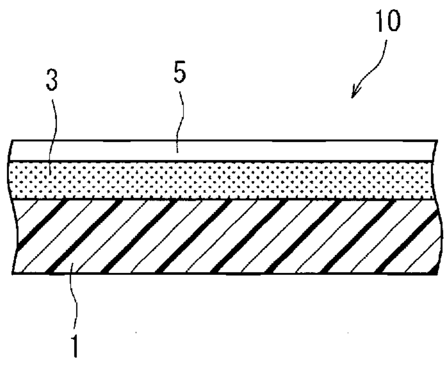


Fig. 2

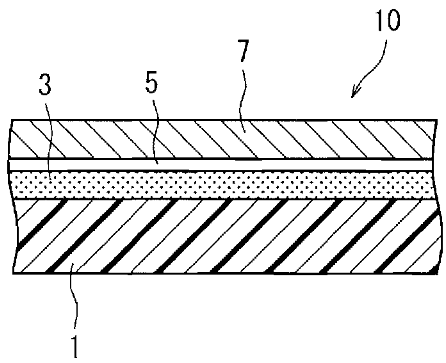


Fig. 3

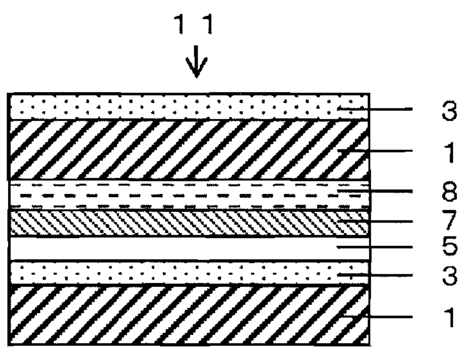

**INTERNATIONAL SEARCH REPORT**

International application No. PCT/JP2015/056105

A. CLASSIFICATION OF SUBJECT MATTER
*B32B9/00*(2006.01)i, *C23C16/40*(2006.01)i, *C23C16/44*(2006.01)i

According to International Patent Classification (IPC) or to both national classification and IPC

B. FIELDS SEARCHED

Minimum documentation searched (classification system followed by classification symbols)
B32B1/00-43/00, C23C16/00-16/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2013/050741 A1 (FUJIFILM MANUFACTURING EUROPE BV),<br>11 April 2013 (11.04.2013),<br>claims; page 12, line 32 to page 13, line 4; examples<br>& JP 2014-534336 A & US 2014/0242365 A1<br>& GB 201117242 D & EP 2764133 A1 | 1-4,6<br>7<br>5 |
| Y | WO 2013/015417 A1 (Toppan Printing Co., Ltd.),<br>31 January 2013 (31.01.2013),<br>claims; paragraph [0045]<br>& EP 2740593 A1<br>claims; paragraph [0046]<br>& US 2014/0141218 A1 & CN 103732393 A<br>& KR 10-2014-0043787 A & TW 201323226 A | 7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>15 May 2015 (15.05.15) | Date of mailing of the international search report<br>26 May 2015 (26.05.15) |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

**INTERNATIONAL SEARCH REPORT**

International application No.
PCT/JP2015/056105

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-236976 A (Toyo Seikan Kaisha, Ltd.), 26 August 2003 (26.08.2003), claims; paragraphs [0019], [0067] to [0074] & US 2003/0165696 A1 claims & WO 2002/092875 A1 & EP 1302560 A1 & DE 60236569 D & CA 2415495 A & TW 570876 B & KR 10-0888990 B1 & AU 2002308940 B | 1-7 |
| A | JP 2011-241421 A (Toppan Printing Co., Ltd.), 01 December 2011 (01.12.2011), claims (Family: none) | 1-7 |
| P,X<br>P,A | JP 2015-3464 A (Konica Minolta, Inc.), 08 January 2015 (08.01.2015), claims; paragraphs [0255] to [0307] (Family: none) | 1-6<br>7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013022253 A
- JP 2000255579 A
- JP 2011241421 A
- JP 2010286285 A